# EUROPEAN PATENT APPLICATION

(11) **EP 2 669 346 A1**
(43) Date of publication of application: **04.12.2013**
(21) Application number: 11856888.0
(22) Date of filing: 30.09.2011
(51) Int. Cl.: C09J 163/00, C09J 11/04, C09J 11/06, H01B 1/22, H01L 31/042

(54) **CONDUCTIVE BINDER COMPOSITION AND METHOD FOR PRODUCING THE SAME, BONDED UNIT, AND SOLAR CELL MODULE AND METHOD FOR PRODUCING THE SAME**

(30) Priority: 27.01.2011 JP 2011015629
(71) Applicant: Hitachi Chemical Co., Ltd., Chiyoda-ku Tokyo 100-6606 (JP)
(72) Inventor: YOKOCHI Seigo, Hitachi-shi Ibaraki 317-8555 (JP); HAYASHI Hiroki, Tsukuba-shi Ibaraki 300-4247 (JP)
(74) Representative: Albrecht, Thomas
(86) International application number: PCT/JP2011/072657
(87) International publication number: WO 2012/101869

(57) **Abstract**

Provided is a conductive adhesive composition which contains conductive particles (A) containing metal having a melting point of equal to or lower than 210°C, a thermosetting resin (B), and a flux activator (C), in which viscosity of the conductive adhesive composition is 5 to 30 Pa·s, and a content of the conductive particles (A) is 70 to 90% by mass with respect to the total amount of the conductive adhesive composition.

## Description

### Technical Field

The present invention relates to a conductive adhesive composition which is suitably used for electrical connection of a plurality of solar battery cells, a method for applying the same, a connected body, and a solar cell module and a method for producing the same.

### Background Art

As means for solving aggravated global warming or fossil energy depletion, attention is paid on a solar battery which is a power generating system using sunlight. A structure in which solar battery cells in which an electrode is formed on a monocrystalline or polycrystalline Si wafer, are connected in series or in parallel to each other via a wiring member, has been employed for the current main solar battery cells. In general, solder which shows excellent conductivity and is inexpensive has been used for the connection of the electrodes of the solar battery cells and the metal wiring member (Patent Literature 1). Further, in recent years, in consideration of environmental problems, a method has been known for applying Sn-Ag-Cu solder, which does not contain Pb, onto a copper wire which is a wiring member, and connecting electrodes of solar battery cells and the wiring member by performing heating to a temperature equal to or higher than a melting temperature of the solder (Patent Literature 1 and 2).

In addition, as an alternative material of the solder, a use of a conductive adhesive capable of electrical connection at a low temperature has been proposed (Patent Literature 3). This conductive adhesive is a composition obtained by mixing and dispersing of metal particles which are typified by silver particles in a thermosetting resin, and the electrical connection is expressed by physical contact with these metal particles to the electrodes of the solar battery cells and the wiring member.

### Citation List

### Patent Literature

[Patent Literature 1] Japanese Unexamined Patent Application Publication No. 2002-263880
[Patent Literature 2] Japanese Unexamined Patent Application Publication No. 2004-204256
[Patent Literature 3] Japanese Unexamined Patent Application Publication No. 2005-243935

### Summary of Invention

### Technical Problem

However, as a method for applying this conductive adhesive onto the electrodes of the solar battery cells, a conventional printing method or a coating method using a contact-type dispenser has been generally used. In a case of using these methods, since it is necessary to stop the solar battery cells during the manufacturing step, for coating, there is a demand for improvement of workability.

Meanwhile, as a method for applying an adhesive, a method has been known using a non-contact-type dispenser. The contact-type dispenser described above is a device which performs coating in a state where the dispenser and a coating target come in contact with each other via a conductive adhesive, however, the non-contact-type dispenser continuously discharges a fixed quantity of the conductive adhesive as liquid droplets, and thus, it is possible to perform the coating without contact with the dispenser and the coating medium through discharged liquid. Since the contact-type dispenser performs coating in a state where the dispenser and a coating medium come in contact with each other via the conductive adhesive, it is necessary to control a height of a discharging position with respect to changes of a coating surface in height, and thus, it is necessary to stop the solar battery cells during the manufacturing method, for the coating. With respect to this, in the non-contact-type dispenser, since the dispenser and the coating medium do not come in contact with each other, such problems do not occur, drawing at a high speed becomes possible and an improvement in work efficiency is expected.

However, since the conductive adhesive in the related art clogs a discharging port of the non-contact-type dispenser, there is a problem of not being able to discharge liquid. In addition, it is desired to have sufficient preservation stability, when performing discharging of the conductive adhesive using the non-contact-type dispenser. Further, the electrical connection at a low temperature is desired when electrically connecting the electrodes of the solar battery cells.

Here, the present invention has been made to address the aforementioned problems and an object thereof is to provide a conductive adhesive composition which is capable of electrical connection at a low temperature, has sufficient preservation stability, and is capable of coating with a non-contact-type dispenser, and a method for applying the same, and a connected body and a solar cell module using the same.

### Solution to Problem

According to the present invention, there is provided a conductive adhesive composition which contains conductive particles (A) containing metal having a melting point of equal to or lower than 210°C, a thermosetting resin (B), and a flux activator (C), in which viscosity of the conductive adhesive composition is 5 to 30 Pa·s, and a content of the conductive particles (A) is 70 to 90% by mass with respect to the total amount of the conductive adhesive composition.

According to the conductive adhesive composition, it is possible to perform electrical connection at a low temperature, to have sufficient preservation stability, and to perform coating with a non-contact-type dispenser.

In addition, in the present specification, the "melting point" is a point measured by Differential scanning calorimetry (DSC), for example.

It is preferable that the metal of the conductive particles (A) contain at least one kind of component selected from bismuth, indium, tin, and zinc. Accordingly, it is possible to decrease the melting point of the conductive particles while maintaining excellent conductivity.

It is preferable that an average particle size of the conductive particles (A) be 2 to 95 µm. Accordingly, the preservation stability and a coating property with the non-contact-type dispenser are improved.

It is preferable that the conductive adhesive composition further contain a curing agent or a curing accelerator. Accordingly, connection stability is further improved.

It is preferable that the thermosetting resin (B) be an epoxy resin. Accordingly, the connection stability is further improved.

In addition, according to the present invention, there is provided a method for applying a conductive adhesive composition, including applying the conductive adhesive composition described above onto a target binding surface by a non-contact-type dispenser. In the applying method, since the conductive adhesive composition described above is used, it is possible to perform coating easily by using the non-contact-type dispenser.

In addition, the "target binding surface" is not particularly limited, however, detailed examples thereof include an electrode, a wiring member, a circuit substrate of a solar cell, and a circuit substrate of a semiconductor.

In addition, according to the present invention, there is provided a connected body in which a plurality of solar battery cells are connected via a metal wire, in which electrode surfaces of the solar battery cells and the metal wire are connected via the conductive adhesive composition described above.

In addition, according to the present invention, there is provided a method for producing a solar cell module including: a step of applying the above described conductive adhesive composition onto electrode surfaces of solar battery cells by a non-contact-type dispenser; a step of laminating a sealing material on both surfaces of the solar battery cells, after disposing a wiring member on the conductive adhesive composition applied onto the electrode surfaces of the solar battery cells; a step of laminating glass on the sealing material on a light-receiving surface side of the solar battery cells, and a protection film on the sealing material on a rear surface of the solar battery cells; and a step of sealing the solar battery cells while electrically connection and bonding the solar battery cells and the wiring member by heating the obtained laminated body.

In addition, according to the present invention, there is provided a solar cell module in which electrodes of a plurality of solar battery cells and a wiring member are electrically connected via the conductive adhesive composition described above.

### Advantageous Effects of Invention

According to the present invention, it is possible to provide the conductive adhesive composition which can perform coating with the non-contact-type dispenser while maintaining electrical characteristics of solar battery cells, and the method for producing the solar cell module using the conductive adhesive composition. In addition, it is possible to efficiently produce the solar cell module by the present invention.

### Brief Description of Drawings

Fig. 1 is a schematic view showing main parts of a solar cell module according to the present invention.
Fig. 2 is a view for illustrating one embodiment of a method for producing a solar cell module according to the present invention.
Fig. 3 is a view for illustrating a method for applying a conductive adhesive composition of the present invention onto surface electrodes of solar battery cells using a non-contact-type dispenser.

### Description of Embodiments

Hereinafter, preferred embodiments of the present invention will be described in detail with reference to the drawings. In addition, in the drawings, the same reference numerals are given to the same or corresponding parts, and the overlapping description is omitted.

A conductive adhesive composition of the present invention contains conductive particles (A), a thermosetting resin (B), and a flux activator (C).

As the conductive particles (A), particles which contain metal having a melting point of equal to or lower than 210°C, more preferably particles which contain metal having a melting point of equal to or lower than 200°C can be used. The lower limit of the melting point of the metal of the conductive particles (A) is not particularly limited, however, it is about 120°C. If such conductive particles are used for the conductive adhesive composition, it is considered that melt and aggregation occur at a relatively low temperature, and this aggregate contributes to the electrical connection of a target object.

In consideration of environmental friendliness, the metal of the conductive particles (A) is preferably constituted from metal other than lead. An example of the metal constituting the conductive particles (A) includes a simple substance or alloy containing at least one kind of component selected from tin (Sn), bismuth (Bi), indium (In), and zinc (Zn). In addition, from a viewpoint of obtaining further excellent connection reliability, the alloy can contain high-melting-point components selected from Pt, Au, Ag, Cu, Ni, Pd, Al, and the like, in a range where melting point of the entire metal of the conductive particles (A) is 210°C.

Specifically, as the metal constituting the conductive particles (A), Sn42-Bi58 solder (melting point of 138°C), Sn48-In52 solder (melting point of 117°C), Sn42-Bi57-Agl solder (melting point of 139°C), Sn90-Ag2-Cu0.5-Bi7.5 solder (melting point of 189°C), Sn96-Zn8-Bi3 solder (melting point of 190°C), Sn91-Zn9 solder (melting point of 197°C), and the like are preferable since they show a clear solidification behavior after melting. The solidification behavior is a behavior of solidified again by being cooled after being melted. Among these, from a view point of availability or a low melting point, Sn-42-Bi58 solder or Sn42-Bi57-Agl solder is preferably used. These are used alone as one kind, or in combination of two or more kinds.

An average particle size of the conductive particles (A) is not particularly limited, however, is preferably 2 to 95 µm. If this average particle size is less than 2 µm, the viscosity of the conductive adhesive composition tends to be increased, and the workability tends to be decreased. In addition, if the average particle size of the conductive particles exceeds 95 µm, a coating property tends to be decreased, and a problem of occurrence of precipitation of the conductive particles in the conductive adhesive composition tends to occur. The coating property denotes a shape retention force at the time of applying the conductive adhesive composition. It is preferable to maintain a coated shape after coating, that is, to have an excellent coating property. From a viewpoint of obtaining the further excellent coating property and workability of the conductive adhesive composition, the average particle size thereof is more preferably 5 to 50 µm. In addition, from a viewpoint of further improving preservation stability of the conductive adhesive composition and mounting reliability of a cured product, this average particle size thereof is particularly preferably 5 µm to 30 µm. Herein, the average particle size is a value measured by a laser diffraction and scattering method (Kamioka Mining Test Method No. 2).

In addition to the particles configured with only the metal having the melting point of equal to or lower than 210°C, the conductive particles (A) may be conductive particles obtained by coating surfaces of particles consisting of solid-state materials other than metal such as ceramics, silica, and resin materials, with a metal film consisting of metal having a melting point of equal to or lower than 210°C, or may be a mixture thereof.

The content of the conductive particles (A) of the conductive adhesive composition is 70 to 90% by mass, with respect to the total amount of the conductive adhesive composition. In a case where the content thereof is less than 70% by mass, aggregability of the metal components is decreased. In addition, if the content thereof exceeds 90% by mass, the viscosity of the conductive adhesive composition is increased and the workability is decreased. Also, since the adhesive components in the conductive adhesive composition are relatively decreased, the mounting reliability of the cured product is decreased. Further, from a viewpoint of improving the workability or conductivity, the content of the conductive particles (A) is more preferably 70 to 85% by mass, and from a viewpoint of improving the mounting reliability of the cured product, the content thereof is particularly preferably 70 to 80% by mass.

In addition, conductive particles (al) consisting of metal having a melting point of higher than 210°C may be used with the conductive particles (A). An example of such metal having a melting point of higher than 210°C includes one kind of metal or alloy consisting of two or more kinds of metal selected from Pt, Au, Ag, Cu, Ni, Pd, Al, and the like, and in more specifically, the examples thereof include Au powder, Ag powder, Cu powder, Ag-plated Cu powder. As a commercially available product, "MA05K" (product name, manufactured by Hitachi Chemical Co., Ltd.) which is silver-plated copper powder.

In a case of using the conductive particles (al) consisting of metal having the melting point of higher than 210°C with the conductive particles (A), a combination ratio thereof is preferably in a range where (A) : (al) is 99:1 to 50:50 by mass ratio, and more preferably in a range where (A) : (al) is 99:1 to 60:40.

A thermosetting resin (B) performs an action of binding a coated object, and functions as a binder component which binds the conductive particles in the adhesive composition and a filler which is added, if necessary, to each other. Examples of such a resin include a thermosetting resin such as an epoxy resin, a (meth)acrylic resin, a maleimide resin, and a cyanate resin, and a precursor thereof. Herein, the (meth)acrylic resin denotes a methacrylic resin and an acrylic resin. Among these, a compound having carbon-carbon double bond which is polymerizable in a molecule represented by the (meth)acrylic resin and the maleimide resin, or the epoxy resin is preferable. In particular, from a viewpoint of adhesion strength at the time of curing, the epoxy resin is preferable. The thermosetting resins described above are excellent in heat resistance and the adhesiveness, and also, since the resins can be used in a liquid state if they are dissolved or dispersed in an organic solvent if necessary, they are also excellent in workability. The thermosetting resin described above is used alone as one kind, or in combination of two or more kinds.

The (meth)acrylic resin is configured from the compound having polymerizable carbon-carbon double bond. Examples of the compound include a monoacrylate compound, a monomethacrylate compound, a diacrylate compound, and a dimethacrylate compound.

Examples of the monoacrylate compound include methyl acrylate, ethyl acrylate, propyl acrylate, isopropyl acrylate, n-butyl acrylate, isobutyl acrylate, t-butyl acrylate, amyl acrylate, isoamyl acrylate, hexyl acrylate, heptyl acrylate, octyl acrylate, 2-ethylhexyl acrylate, nonyl acrylate, decyl acrylate, isodecyl acrylate, lauryl acrylate, tridecyl acrylate, hexadecyl acrylate, stearyl acrylate, isostearyl acrylate, cyclohexyl acrylate, isobornyl acrylate, diethylene glycol acrylate, polyethylene glycol acrylate, polypropylene glycol acrylate, 2-methoxyethyl acrylate, 2-ethoxyethyl acrylate, 2-butoxyethyl acrylate, methoxy diethylene glycol acrylate, methoxy polyethylene glycol acrylate, dicyclopentenyloxyethyl acrylate, 2-phenoxyethyl acrylate, phenoxy diethylene glycol acrylate, phenoxy polyethylene glycol acrylate, 2-benzoyloxyethyl acrylate, 2-hydroxy-3-phenoxypropyl acrylate, benzyl acrylate, 2-cyanoethyl acrylate, γ-acryloxyethyl trimethoxysilane, glycidyl acrylate, tetrahydrofurfuryl acrylate, dimethylaminoethyl acrylate, diethylaminoethyl acrylate, acryloxyethyl phosphate, and acryloxyethylphenyl acid phosphate.

Examples of the monomethacrylate compound include methyl methacrylate, ethyl methacrylate, propyl methacrylate, isopropyl methacrylate, n-butyl methacrylate, isobutyl methacrylate, t-butyl methacrylate, amyl methacrylate, isoamyl methacrylate, hexyl methacrylate, heptyl methacrylate, octyl methacrylate, 2-ethylhexyl methacrylate, nonyl methacrylate, decyl methacrylate, iso-decyl methacrylate, lauryl methacrylate, tridecyl methacrylate, hexadecyl methacrylate, stearyl methacrylate, isostearyl methacrylate, cyclohexyl methacrylate, isobornyl methacrylate, diethylene glycol methacrylate, polyethylene glycol methacrylate, polypropylene glycol methacrylate, 2-methoxyethyl methacrylate, 2-ethoxyethyl methacrylate, 2-butoxyethyl methacrylate, methoxy diethylene glycol methacrylate, methoxy polyethylene glycol methacrylate, dicyclopentenyloxyethyl methacrylate, 2-phenoxyethyl methacrylate, phenoxydiethylene glycol methacrylate, phenoxypolyethylene glycol methacrylate, 2-benzoyloxyethyl methacrylate, 2-hydroxy-3-phenoxypropyl methacrylate, benzyl methacrylate, 2-cyanoethyl methacrylate, γ-methacryloxyethyl trimethoxysilane, glycidyl methacrylate, tetrahydrofurfuryl methacrylate, dimethylaminoethyl methacrylate, diethylaminoethyl methacrylate, methacryloxyethyl phosphate, and methacryloxyethylphenyl acid phosphate.

Examples of the diacrylate compound include ethylene glycol diacrylate, 1,4-butanediol diacrylate, 1,6-hexanediol diacrylate, 1,9-nonanediol diacrylate, 1,3-butanediol diacrylate, neopentyl glycol diacrylate, diethylene glycol diacrylate, triethylene glycol diacrylate, tetraethylene glycol diacrylate, polyethylene glycol diacrylate, triethylene glycol diacrylate, polypropylene glycol diacrylate, a resultant of reaction between 1 mole of bisphenol A, bisphenol F, or bisphenol AD and 2 moles of glycidyl acrylate, diacrylate of a polyethylene oxide adduct of bisphenol A, bisphenol F, or bisphenol AD, diacrylate of a polypropylene oxide adduct of bisphenol A, bisphenol F, or bisphenol AD, bis(acryloxypropyl) polydimethylsiloxane, and a bis(acryloxypropyl)methylsiloxane-dimethylsiloxane copolymer.

Examples of the dimethacrylate compound include ethylene glycol dimethacrylate, 1,4-butanediol dimethacrylate, 1,6-hexanediol dimethacrylate, 1,9-nonanediol dimethacrylate, 1,3-butanediol dimethacrylate, neopentyl glycol dimethacrylate, diethylene glycol dimethacrylate, triethylene glycol dimethacrylate, tetraethylene glycol dimethacrylate, polyethylene glycol dimethacrylate, tripropylene glycol dimethacrylate, polypropylene glycol dimethacrylate, a resultant of reaction between 1 mole of bisphenol A, bisphenol F, or bisphenol AD, and 2 moles of glycidyl methacrylate, dimethacrylate of a polyethylene oxide adduct of bisphenol A, bisphenol F, or bisphenol AD, a polypropylene oxide adduct of bisphenol F or bisphenol AD, bis (methacryloxypropyl) polydimethylsiloxane, and a bis (methacryloxypropyl) methyl siloxane-dimethyl siloxane copolymer.

These compounds are used alone as one kind, or in combination of two or more kinds. In addition, when containing the (meth)acrylic resin as the thermosetting resin, these compound may be used after performing polymerization in advance, or the compounds may be mixed with the conductive particles (A) and the flux activator (C) and polymerization may be performed at the same time as the mixing.

When the thermosetting resin is configured from the compound having polymerizable carbon-carbon double bond, the conductive adhesive composition preferably contains a radical polymerization initiator. From a viewpoint of efficiently suppressing voids and the like, organic peroxide is suitable for the radical polymerization initiator. In addition, from a viewpoint of improving curing property and viscosity stability of the conductive adhesive composition, a decomposition temperature of the organic peroxide is preferably 70 to 170°C, and more preferably 80 to 160°C.

Examples of the radical polymerization initiator include 1,1,3,3,-tetramethylbutylperoxy-2-ethylhexanoate, 1,1-bis(t-butylperoxy)cyclohexane, 1,1-bis(t-butylperoxy)cyclododecane, di-t-butylperoxyisophthalate, t-butylperoxybenzoate, dicumyl peroxide, t-butylcumyl peroxide, 2,5-dimethyl-2,5-di(t-butylperoxy)hexane, 2,5-dimethyl-2,5-di(t-butylperoxy)-3-hexyne, and cumene hydroperoxide. These may be used alone as one kind or in combination of two or more kinds.

A combination rate of the radical polymerization initiator is preferably 0.01 to 20% by mass, more preferably 0.1 to 10% by mass, and even more preferably 0.5 to 5% by mass, with respect to the total amount of the components other than the conductive particles and solvent of the conductive adhesive composition (hereinafter, referred to as an "adhesive component).

A commercially available resin can be used for the acrylic resin. As a specific example, FINEDIC A-261 (product name, manufactured by DIC Corporation, softening point: 105 ± 3°C), FINEDIC A-229-30 (product name, manufactured by DIC Corporation, softening point: 109 ± 3°C), and the like are used. In addition, the "softening point" refers to a value measured by a rheometer which can change a measurement temperature, for example.

The epoxy resin is not particularly limited as long as it is a compound having two or more epoxy groups in one molecule thereof, and well-known compounds can be used. Examples of the epoxy resin include a condensation product of bisphenol A, bisphenol AD, bisphenol S, bisphenol F, or halogenated bisphenol A, and epichlorohydrin, glycidyl ether of a phenol novolac resin, glycidyl ether of a cresol novolac resin, and glycidyl ether of a bisphenol A novolac resin.

A commercially available product can be used for such an epoxy resin. As detailed examples, AER-X8501 (product name, manufactured by Asahi Kasei Corporation), R-301 (product name, manufactured by Japan Epoxy Resin Co., Ltd.), and YL-980 (product name, manufactured by Japan Epoxy Resin Co., Ltd.) which are bisphenol A-type epoxy resins, YDF-170 (product name, manufactured by Tohto Kasei Co., Ltd.) and YL-983 (product name, manufactured by Japan Epoxy Resin Co., Ltd.) which are bisphenol F-type epoxy resins, R-1710 (product name, manufactured by Mitsui Petrochemical Industries) which is a bisphenol AD-type epoxy resin, N-730S (product name, manufactured by DIC Corporation) and Quatrex-2010 (product name, manufactured by The Dow Chemical Company) which are phenol novolac type epoxy resins, YDCN-702S (product name, manufactured by Tohto Kasei Co., Ltd.) and EOCN-100 (product name, manufactured by NIPPON KAYAKU Co., Ltd.) which are cresol novolac type epoxy resins, EPPN-501 (product name, manufactured by NIPPON KAYAKU Co., Ltd.), TACTIX-742 (product name, manufactured by The Dow Chemical Company), VG-3010 (product name, manufactured by Mitsui Petrochemical Industries), and 1032S (product name, manufactured by Japan Epoxy Resin Co., Ltd.) which are multifunctional epoxy resins, HP-4032 (product name, manufactured by DIC Corporation) which is an epoxy resin having a naphthalene skeleton, EHPE-3150 and CEL-3000 (product names, both manufactured by Daicel Corporation), DME-100 (product name, manufactured by New Japan Chemical Co., Ltd.), and EX-216L (product name, manufactured by Nagase ChemteX Corporation) which are alicyclic epoxy resins, W-100 (product name, manufactured by New Japan Chemical Co., Ltd.) which is an aliphatic epoxy resin, ELM-100 (product name, manufactured by Sumitomo Chemical Co., Ltd.), YH-434L (product name, manufactured by Tohto Kasei Co., Ltd.), TETRAD-X and TETRAD-C (product names, both manufactured by Mitsubishi Gas Chemical Company), and 630 and 630LSD (product names, both manufactured by Japan Epoxy Resin Co., Ltd.) which are amine type epoxy compounds, DENACOL EX-201 (product name, manufactured by Nagase ChemteX Corporation) which is a resorcin type epoxy resin, DENACOL EX-211 (product name, manufactured by Nagase ChemteX Corporation) which is a neopentyl glycol type epoxy resin, DENACOL EX-212 (product name, manufactured by Nagase ChemteX Corporation) which is a hexanediol glycol type epoxy resin, DENACOL EX series (EX-810, 811, 850, 851, 821, 830, 832, 841, and 861 (product names, all manufactured by Nagase ChemteX Corporation)) which are ethylene·propylene glycol type epoxy resins, and E-XL24, and E-XL-3L (product names, all manufactured by Mitsui Chemicals, Inc.) which are epoxy resins represented by the following general formula (I). Among these epoxy resins, the bisphenol A-type epoxy resin, the bisphenol F-type epoxy resin, the bisphenol AD-type epoxy resin, and the amine type epoxy resin having less ionic impurities and excellent reactivity are particularly preferable. 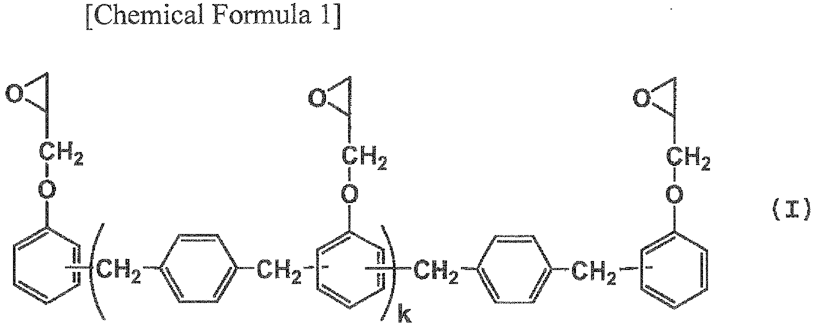 (In Formula (I), k represents an integer from 1 to 5.)

The epoxy resins described above are used alone as one kind, or in combination of two or more kinds.

In addition, in a case where the conductive adhesive composition contains the epoxy resins described above as the thermosetting resin, an epoxy compound having only one epoxy group in one molecular may be further contained as a reactive diluent. Such epoxy compounds are available as commercially available products, and specific examples thereof include PGE (product name, manufactured by NIPPON KAYAKU Co., Ltd.), PP-101 (product name, manufactured by Tohto Kasei Co., Ltd.), ED-502, ED-509, and ED-509S (product names, manufactured by ADEKA CORPORATION), YED-122 (product name, manufactured by Japan Epoxy Resin Co., Ltd.), KBM-403 (product name, manufactured by Shin-Etsu Chemical Co., Ltd.), and TSL-8350, TSL-8355, and TSL-9905 (product names, manufactured by Toshiba Silicones Co., Ltd.). These are used alone as one kind or in combination of two or more kinds.

Content in a case of containing the reactive diluent, may be in a range of not disturbing the effects of the present invention, and preferably 0.1 to 30% by mass with respect to the total amount of the epoxy resins.

In a case where the conductive adhesive composition contains the epoxy resins as the thermosetting resin, it is further suitable to contain a curing agent or a curing accelerator.

An example of the curing agent is not particularly limited as long as it is conventionally used, and the commercially available product can be used. Examples of the commercially available curing agent include H-1 (product name, manufactured by Meiwa Plastic Industries, Ltd.) and VR-9300 (product name, manufactured by Mitsui Toatsu Chemicals, Inc.) which are phenol novolac resins, XL-225 (product name, manufactured by Mitsui Toatsu Chemicals, Inc.) which is a phenol aralkyl resin, MTPC (product name, manufactured by Honshu Chemical Industry Co., Ltd.) which is p-cresol novolac resin represented by the following General Formula (II), AL-VR-9300 (product name, manufactured by Mitsui Toatsu Chemicals, Inc.) which is an allylated phenol novolac resin, and PP-700-300 (product name, manufactured by Nippon Petrochemicals Co., Ltd.) which is a specialized phenol resin represented by the following General Formula (III). 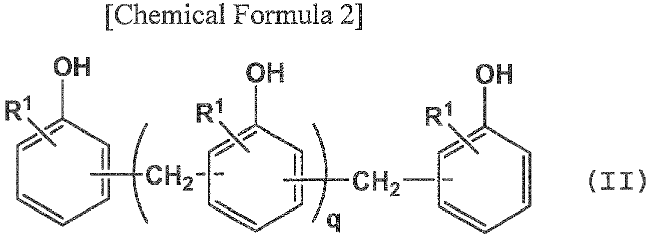 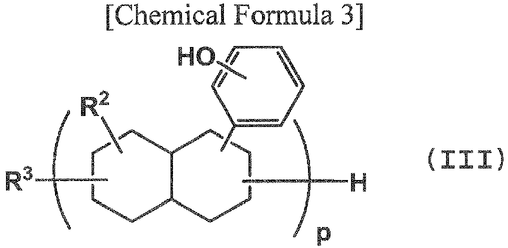 (In Formula (II), R¹ independently represents a monovalent hydrocarbon group, preferably, a methyl group or an aryl group, and q represents an integer from 1 to 5. In addition, in Formula (III), R² represents an alkyl group, preferably a methyl group or an ethyl group, R³ represents a hydrogen atom or a monovalent hydrocarbon group, and p represents an integer from 2 to 4.)

The combination rate of the curing agent is preferably a rate to have the total amount of the reaction activity group in the curing agent of equivalent amounts of 0.3 to 1.2, more preferably a rate to have the total amount thereof equivalent amounts of 0.4 to 1.0, and even more preferably a rate to have the total amount thereof equivalent amounts of 0.5 to 1.0, with respect to the equivalent amount of 1.0 of the epoxy group of the epoxy resin. If the amount of the reaction activity group is less than equivalent amount of 0.2, reflow crack resistance of the adhesive components tends to be decreased, and if the amount thereof exceeds equivalent amount of 1.2, the viscosity of the adhesive components tends to be increased and the workability tends to be decreased. The reaction activity group is a substituted group having reaction activity with the epoxy resin, and a phenolic hydroxyl group is used, for example.

In addition, the curing accelerator is not particularly limited as long as it is used as a curing accelerator of the related art, such as dicyandiamide, and commercially available products can be used. Examples of the commercially available products include ADH, PDH, and SDH (product names, all manufactured by Japan Finechem Company, Inc.) which are dibasic acid dihydrazide represented by the following General Formula (IV), and NOVACURE (product name, manufactured by Asahi Kasei Corporation) which is a microcapsule type curing agent consisting of a resultant of reaction between epoxy resins and amine compounds. These curing accelerators are used alone as one kind or in combination of two or more kinds.

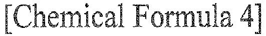

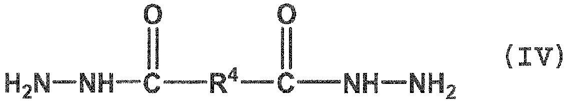

(In Formula (IV), R⁴ represents divalent aromatic group or a linear or branched alkylene group having 1 to 12 carbon atoms, preferably an m-phenylene group or a p-phenylene group.)

The combination rate of the curing accelerator is preferably 0.01 to 90 parts by mass, and more preferably 0.1 to 50 parts by mass, with respect to 100 parts by mass of the epoxy resin. If the combination rate of the curing accelerator is less than 0.01 parts by mass, the curing property tends to be decreased, and if the combination rate thereof exceeds 90 parts by mass, the viscosity is increased, and workability at the time of using the adhesive components tends to be decreased.

In addition to or instead of the examples described above, as the commercially available curing accelerator, EMZ·K, and TPPK (product names, all manufactured by Hokko Chemical Industry Co., Ltd.) which are organic boron salt compounds, DBU, U-CAT 102, 106, 830, 840, and 5002 (product names, all manufactured by San-Apro Ltd.) which are tertiary amines or salts thereof, and CUREZOL, 2PZ-CN, 2P4MHZ, C 17Z, 2PZ-OK, 2PZ-CNS, and C11Z-CNS (product names, all manufactured by Shikoku Chemicals Corporation) which are imidazoles, may be used.

The combination rate of these curing accelerator is preferably 0.1 to 20 parts by mass, and more preferably 0.1 to 15 parts by mass, with respect to 100 parts by mass of the epoxy resin.

In addition, the curing agent and the curing accelerator may be used alone as one kind or in combination of two or more kinds, respectively.

The content of the thermosetting resin (B) of the conductive adhesive composition is preferably 1 to 60% by mass, more preferably 5 to 40% by mass, and particularly preferably 10 to 30% by mass, with respect to the total amounts of the adhesive components.

Further, in addition to the thermosetting resins described above, one kind or two or more kinds of thermoplastic resins which function as a binder may be added to the conductive adhesive composition of the present invention. Examples of the thermoplastic resins include ABS resins (acrylonitrile, butadiene, and styrene copolymerization synthetic resins), polypropylene resins, polyethylene resins, polyvinyl chloride resins, polystyrene resins, polymethyl methacrylate resins, polybutadiene resins, polyethylene terephthalate resins, polyphenylene ether resins, nylon resins, polyamide resins, polycarbonate resins, polyacetal resin, polybutylene terephthalate resin, polyphenylene sulfide resins, polyether ether ketone resins, modified polyphenylene ether resins, liquid crystal polymers, fluorine resins, urethane resins, polyarylate resins, polyimide resins, polyamide imide resins, polyetherimide resins, polyether sulfone resins, and polysulfone resins. These thermoplastic resins are used alone as one kind or in combination of two or more kinds.

The flux activator (C) shows a function of removing an oxide film formed on the surfaces of the conductive particles (A). By using such a flux activator, the oxide film which is disturbance of the aggregation of the conductive particles (A) is removed. The flux activator (C) is not particularly limited as long as it is a compound which does not disturb a curing reaction of the thermosetting resin (B), and a well-known compound can be used. Examples of the compounds include a rosin resin, a compound containing a carboxyl group, a phenolic hydroxyl group, or an alcoholic hydroxyl group in a molecule, dibasic acid having an alkyl group on a side chain such as 2,4-diethyl glutaric acid, 2,2-diethyl glutaric acid, 3-methyl glutaric acid, 2-ethyl-3-propyl glutaric acid, 2,5-diethyl adipic acid, however, since excellent flux activity is shown and excellent reactivity with the epoxy resin used as the thermosetting resin (B) is shown, the compound containing a hydroxyl group or a carboxyl group in a molecule is preferable and aliphatic dihydroxycarbon acid is particularly preferable. Specifically, a compound represented by the following General Formula (V) or tartaric acid is preferable. 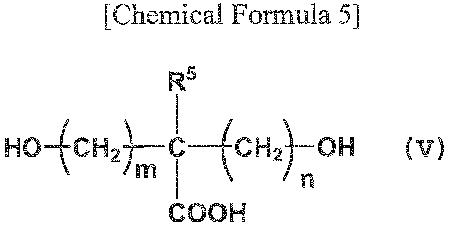 Herein, in Formula (V), R⁵ represents an alkyl group having 1 to 5 carbon atoms, and from a viewpoint of further efficiently exhibiting the effects by using the compound represented by General Formula (V), a methyl group, an ethyl group, or a propyl group is preferable. In addition, n and m independently represent an integer from 0 to 5, and from a viewpoint of further efficiently exhibiting the effects by using the compounds represented by General Formula (V), it is preferable that n be 0 and m be 1, or both n and m be 1, and it is more preferable that both n and m be 1.

Examples of the compound represented by General Formula (V) include 2,2-bis(hydroxylmethyl)propionic acid, 2,2-bis(hydroxymethyl)butyric acid, and 2,2-bis(hydroxymethyl)pentanoic acid.

From a viewpoint of further efficiently exhibiting the effects of the present invention, the content of the flux activator (C) is preferably 0.1 to 30 parts by mass, with respect to 100 parts by mass of the total amount of the conductive particles (A). Further, from viewpoints of the preservation stability and the conductivity, the content thereof is more preferably 0.5 to 20 parts by mass, and even more preferably 1 to 10 parts by mass.

In a case where the content of the flux activator (C) is less than 0.1 parts by mass, a melting property of the metal of the conductive particles (A) tends to be decreased, and the conductivity tends to be decreased, and in a case where the content thereof exceeds 20 parts by mass, the preservation stability and the coating property tend to be decreased.

In order to improve the adhesion, the conductive adhesive composition may contain a coupling agent such as a silane coupling agent or a titanium coupling agent. As the silane coupling agent, "KBM-573" which is a product name manufactured by Shin-Etsu Chemical Co., Ltd. is used, for example. In addition, in order to improve wettability, an anionic surfactant or fluorine surfactant may be contained in the adhesive components. Further, silicone oil or the like may be contained as a defoamer. The adhesion improving agent, the wettability improving agent, and defoamer are used alone as one kind or in combination of two or more kinds. 0.1 to 10% by mass of these is preferably contained with respect to the total amounts of the conductive adhesive composition.

The conductive adhesive composition may contain filler. Examples of the filler include polymer particles such as acrylic rubber or polystyrene, and inorganic particles such as diamond, boron nitride, aluminum nitride, alumina, and silica. These filler may be used alone as one kind or in combination or two or more kinds.

In addition to the respective components described above, the conductive adhesive composition may contain one kind or more additives selected from a group consisting of a flexibility imparting agent for stress relaxation, diluents for improving the workability, an adhesiveness improving agent, a wettability improving agent, and defoamer. In addition to these components, various additives may be contained in a range of not disturbing the effects of the present invention.

For example, as the flexibility imparting agent, liquid polybutadiene such as CTBN-1300X31, CTBN-1300X9 (product names, all manufactured by Ube industries, Ltd.), and NISSO-PB-C-2000 (product name, manufactured by Nippon Soda Co., Ltd.) may be used. In a case of containing the flexibility imparting agent, the content thereof is suitably 0.01 to 500 parts by mass, with respect to 100 parts by mass of the total amount of the thermosetting resin.

In order to have further excellent workability at the time of manufacturing a paste composition and the coating workability at the time of using it, organic solvents can be added to the conductive adhesive composition, if necessary. As such organic solvents, organic solvents having a relatively high boiling point such as butyl cellosolve, carbitol, butyl cellosolve acetate, carbitol acetate, dipropylene glycol monomethyl ether, ethylene glycol diethyl ether, α-terpineol, and the like are preferable. The organic solvents are preferably contained to be 0.1 to 30% by mass with respect to the total amounts of the adhesive composition.

In the present invention, any of the exemplified respective components described above may be combined.

The viscosity of the conductive adhesive composition described above is 5 to 30 Pa·s. If the viscosity exceeds 30 Pa·s, flying of liquid is difficult to be performed, and the coating work by the non-contact-type dispenser is difficult to be performed. If a nozzle size is increased, discharging performance improves, however, it is difficult to draw a thin line having a width of equal to or less than 2.0 mm of the conductive adhesive composition applied onto the target binding surface. The line width of the conductive adhesive composition is not thickened on the solar battery cells and it is preferably thin from a viewpoint of workability. If the viscosity is lower than 5 Pa·s, the conductive particles tends to be precipitated and separated. The viscosity is more preferably 10 to 30 Pa·s, and particularly preferably 20 to 30 Pa·s from viewpoints of preventing precipitation or separation and improving stability.

By performing mixing, dissolving, kneading or dispersing of each component described above at one time or at plural times, and by heating if necessary, the conductive adhesive composition described above is obtained as a paste-like composition in which each component is evenly dispersed. As a device for dispersing and dissolving used at this time, a well-known stirrer, a Raikai mixer, a triple roller, a planetary mixer, or the like is used.

The dispenser which is used when applying the conductive adhesive composition of the embodiment onto the target binding surface by the non-contact-type dispenser is not particularly limited as long as it can perform applying of the conductive adhesive composition with respect to the base material in a non-contact manner, however, the interval between the target binding surface and a discharging port of the dispenser is preferably 0.3 to 5.0 mm, more preferably 0.5 to 2.5 mm, and even more preferably 0.5 to 1.5 mm. If the interval thereof is smaller than 0.3 mm, drag of liquid droplets occurs without disconnection of the liquid droplets between the discharging port and the target binding surface, and if the interval thereof is larger than 5.0 mm, position precision for applying onto the target binding surface may be degraded.
In addition, an internal diameter of a nozzle is preferably 100 to 300 mm and more preferably 120 to 250 mm. If the internal diameter thereof is smaller than 100 mm, clogging easily occurs at the time of the discharging, and if the internal diameter thereof is larger than 300 mm, the line width becomes larger, and the line tends to be protruded at the time of pressure bonding in manufacturing the solar cell module.
Such devices are provided as E-Star series (manufactured by SAN-EI TECH Ltd.) and AeroJet series (manufactured by Musashi Engineering, Inc.) from SAN-EI TECH Ltd. and Musashi Engineering, Inc.

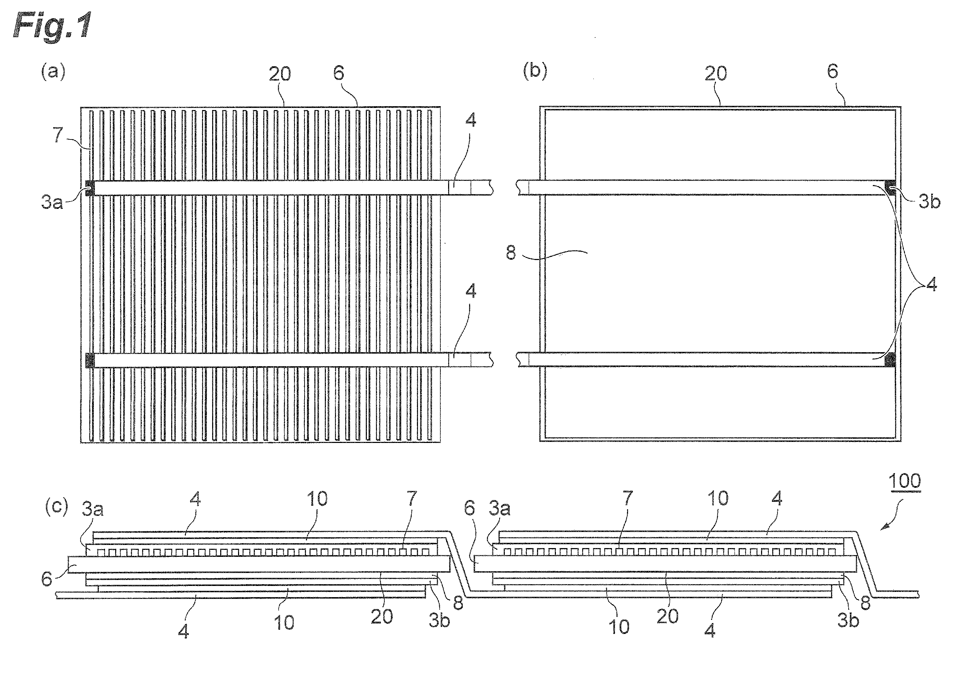

Next, an example of the solar cell module manufactured using the conductive adhesive composition of the embodiment will be described with reference to Fig. 1.

Fig. 1 is a schematic view showing main parts of the solar cell module, and shows an outline of a structure in which the plurality of solar battery cells are connected to each other by wires, as an example. Fig. 1(a) shows a front surface side of the solar cell module, Fig. 1(b) shows a rear surface side, and Fig. 1(c) shows a side surface side.

As shown in Figs. 1(a) to 1(c), in a solar cell module 100, a plurality of solar battery cells 20 in which each of, a grid electrode 7 and a busbar electrode (surface electrode) 3a are formed on a front surface side of a semiconductor wafer 6, and a rear surface electrode 8 and a busbar electrode (surface electrode) 3b are formed on a rear surface side thereof, are connected to each other by wiring members 4. One end and the other end of the wiring member 4 are electrically connected to the busbar electrode 3a as a surface electrode and the busbar electrode 3b as a surface electrode respectively, via the conductive adhesive composition 10 of the embodiment. The conductive adhesive composition of the embodiment is applied onto any one of or both of the electrodes of the surfaces of the solar battery cells and the wiring members using the non-contact-type dispenser.

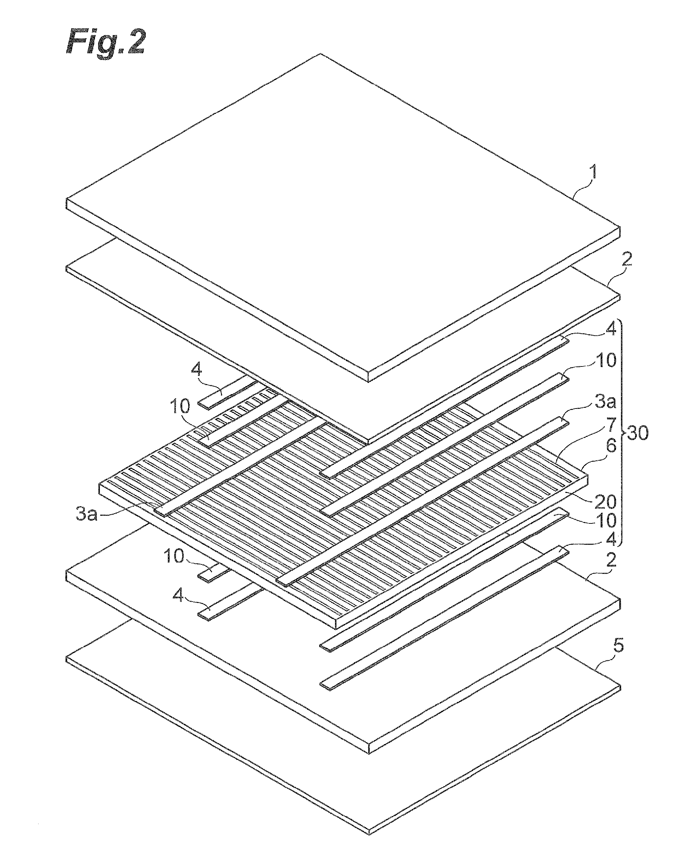

Fig. 2 is a view for illustrating one embodiment of a method for producing the solar cell module of the embodiment.

For example, the solar cell module of the embodiment is manufactured by a production method including: a step of applying the conductive adhesive composition 10 of the embodiment onto the busbar electrodes 3a and 3b by the non-contact-type dispenser; a step of disposing the wiring members 4 on the conductive adhesive composition 10 applied onto the busbar electrodes 3a and 3b to manufacture a connected body 30; a step of disposing sealing materials 2 onto both surfaces of the connected body 30; and a step of disposing glass 1 on the sealing material 2 on a light-receiving surface side of the solar battery cell 20, and a back sheet 5 (protection film) on the sealing material 2 on a rear surface side of the solar battery cell 20, and performing heating pressure bonding of the obtained laminated body with a pressure of 0.1 to 6 MPa at a temperature of 140 to 210°C for 1 to 30 minutes. In this step of heating pressure bonding, the electrical connection and the bonding by the curing of the thermosetting resin between the busbar electrodes 3a and 3b of the solar battery cells 20 and the wiring members 4 are performed, and at the same time, the sealing of the solar battery cells 20 is performed, and thus, the solar cell module can be collectively manufactured.

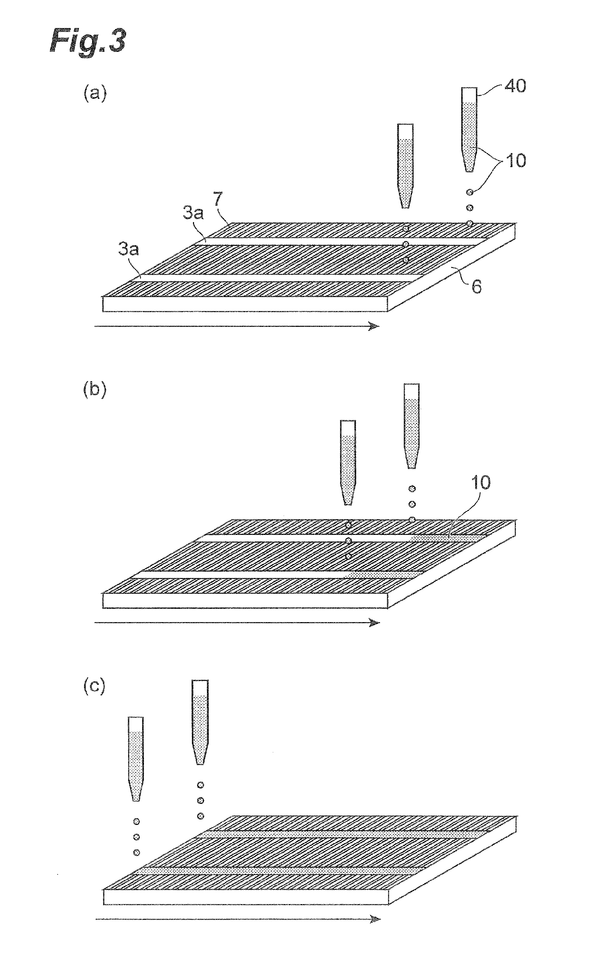

Fig. 3 is a view for illustrating a method for applying the conductive adhesive composition of the present invention onto the surface electrodes of the solar battery cells by the non-contact-type dispenser.

According to this applying method, by continuously discharging the constant amount of the conductive adhesive composition 10 with respect to the busbar electrode 3a by the non-contact-type dispenser 40, while moving the solar battery cells in a direction parallel with the busbar electrode 3a, it is possible to apply the conductive adhesive composition 10 linearly along the electrodes. By disposing the wiring members 4 thereon, it is possible to obtain the connected unit 30. By performing the application of the conductive adhesive composition by the non-contact-type dispenser, it is possible to perform the application thereof without stopping transporting of the solar battery cells, and accordingly, it is possible to improve the manufacturing efficiency of the solar cell module.

Other than these manufacturing method, after disposing the wiring members 4 and the busbar electrodes 3a and 3b so as to face to each other via the conductive adhesive composition 10, preliminary pressure bonding in which the electrical connection of the busbar electrodes 3a and 3b and the wiring members 4 is conducted by performing heating pressure bonding with pressure of 0.1 to 6.0 MPa at a temperature of 140 to 210°C for 1 to 30 minutes may be performed. By performing the preliminary pressure bonding, since the connection of the solar battery cells and the wiring members 4 is performed, it is easy to handle the connected unit 30 and the workability at the time of manufacturing the solar cell module is improved.

In a case of performing the preliminary pressure bonding, the sealing materials 2 are disposed on both surfaces of the obtained connected body 30, the glass 1 is disposed on the sealing material 2 of the solar battery cell 20 on a light-receiving surface side, a back sheet 5 (protection film) is disposed on the sealing material 2 of the solar battery cell 20 on a rear surface side, the obtained laminated body is subject to heating pressure bonding with pressure of 0.1 to 6 MPa at a temperature of 140 to 180°C for 1 to 30 minutes to seal the solar battery cells, and thus, the solar cell module can be manufactured.

Dimpled whiteboard-reinforced glass for solar battery cells may be used for the glass 1. Ethylene-vinyl acetate copolymer resins (EVA) or sealing resins using polyvinylbutyral may be used for the sealing material 2. TAB lines obtained by performing dipping or plating of solder to a Cu line may be used for the wiring members 4. PET-based or Tedlar-PET laminated material, metal foil-PET laminated material may be used for the back sheet 5.

Even in a case of using the circuit substrate in which a metal wire is formed on a plastic substrate, the conductive adhesive composition of the embodiment can connect with the electrodes of the solar battery cells in the steps described above. In addition, even in a case of using a film-like circuit substrate, the connection with the electrodes of the solar battery cells can be performed in the same steps as described above using the conductive adhesive composition of the embodiment.

The cured product of the conductive adhesive composition of the embodiment can be used as a substrate, an electronic component, and a conductive layer which bonds and electrically connects the substrate and the electronic component. In addition, the cured product thereof can also be used as a support base material for semiconductor mounting, a semiconductor element, and as a conductive layer which bonds and electrically connects the support base material and the semiconductor element.

In addition, the conductive adhesive composition of the embodiment can also be used for the connection of the electrodes of the rear surface electrode-type (back contact-type) solar battery cells and the wiring members. In this case, first, the conductive adhesive composition of the embodiment is applied onto the electrodes of the circuit substrates or onto the rear surface electrodes of the solar battery cells. Then, the sealing material obtained by gouging the electrode portion (applied portion of the conductive adhesive composition) of the circuit substrate out is laminated on the circuit substrate, the solar battery cells are disposed thereon so that the rear surface electrodes of the solar battery cells and the electrode portions of the circuit substrates are connected via the conductive adhesive composition. Further, the sealing materials and glass are disposed on the light-receiving surfaces of the solar battery cells, the back sheets are disposed on the rear surface side of the solar battery cells, and heating pressure bonding of this solar cell module is performed, and thus, the connection and binding of the rear surface electrodes of the solar battery cells and the electrodes of the circuit substrates, and the sealing step of the solar battery cells can be collectively performed. As the glass and sealing materials, the examples used in the method for producing the solar cell module can be used.

### Examples

Hereinafter, the present invention will be described in more detail with Examples, however, the present invention is not limited to the Examples. In addition, the materials used in Examples and Comparative Examples are manufactured in the method described below or purchased. One example of the producing method is shown in Example 1, resin composition and combination ratios of the other Examples and Comparative Examples are as shown in Tables 1 and 2, and the producing methods thereof are in the same manner as Example 1.

### [Example 1]

20.0% by mass of YL983-U (product name of bisphenol F-type epoxy resin, manufactured by Mitsubishi Chemical Corporation), 1.0% by mass of 2P4MHZ-PW (product name of 2-phenyl-4-methyl-5-hydroxymethyl imidazole, manufactured by Shikoku Chemicals Corporation), and 4.0% by mass of BHPA (product name of 2,2-bis(hydroxymethyl)propionic acid, manufactured by Tokyo Chemical Industry Co., Ltd.) were mixed to each other, and were passed through a triple roller three times, to produce an adhesive component.

Then, 75% by mass of Sn42-Bi58 particles (average particle size of 20 µm, melting point: 138°C) which are conductive particles were added and mixed with respect to 25% by mass of the adhesive component described above. Further, after passing the triple roller through the mixture thereof three times, a defoaming process was performed at equal to or less than 500 Pa for 10 minutes by using a vacuum stirring Raikai mixer to obtain a conductive adhesive composition.

### [Examples 2 to 7 and Comparative Examples 1 to 5]

Conductive adhesive compositions of Examples 2 to 7 and Comparative Examples 1 to 5 were obtained in the same manner as Example 1 except for composition shown in Tables 1 and 2. In addition, the details of the materials shown in Tables 1 and 2 are as follows. Further, the unit of the combination rates of each material in Tables 1 and 2 is % by mass.
Sn42-Bi57-Agl particles: melting point of 139°C Sn96.5-Ag3-Cu0.5 particles: melting point of 217°C
TETRAD-X: amine-type epoxy compound, product name, manufactured by Mitsubishi Gas Chemical Company
(see the following Formula (VI)) 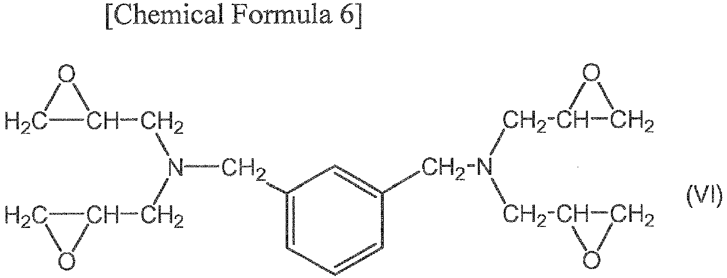 ED-509S: p-tert-butylphenyl glycidyl ether, reactive diluents, product name, manufactured by ADEKA CORPORATION

Properties of the liquid conductive adhesive compositions according to Examples 1 to 7 and Comparative Examples 1 to 5 were measured by the following methods. The results thereof were collectively shown in Tables 1 and 2.

### [Viscosity]

For the viscosity, viscosity at 25°C and 2.5 rpm was measured according to eddy-fluted rotating disk system viscosity measurement based on JIS Z 3284 (using TV-33H type viscometer, SPP rotor manufactured by Toki Sangyo Co., Ltd.).

### [Evaluation of Stability]

When the conductive adhesive compositions obtained in Examples 1 to 7 and Comparative Examples 1 to 5 were observed after leaving it at 25°C for 24 hours, a state where abnormal appearance such as precipitation or separation was not observed visually was set to A, a state where evenness could be realized by slight stirring with a scoopula although appearance of slight separation or precipitation were observed was set to B, and a case where evenness could not be realized by slight stirring with a scoopula for the change of appearance was set to C.

### [Evaluation of Coating Properties and Measurement of Line Width]

The conductive adhesive compositions obtained in Examples 1 to 7 and Comparative Examples 1 to 5 were applied onto the surface electrodes (material: silver glass paste, 2 mm x 125 mm) formed on the light-receiving surfaces of the solar battery cells (125 mm x 125 mm, thickness of 310 µm) by using the non-contact-type dispenser (product name: E-STAR manufactured by SAN-EI TECH Ltd. having a inner diameter of nozzle of 210 µm), and the evaluation of coating properties and measurement of widths of coating lines were performed with the following criteria.
A: Stabilized continuous coating of equal to or more than 100,000 shots can be performed.
B: Flying of liquid is performed, but the dispenser is clogged within 100,000 shots.
C: Within 100,000 shots, coating clogging is realized and flying of liquid is not realized.

### [Evaluation of Aggregability]

After heating the conductive adhesive composition applied in the evaluation of coating properties on a hot plate at 160°C for 10 minutes, the aggregating state of metal of the conductive particles were confirmed with X-ray fluoroscope (SMX-1000, micro focus X-ray fluoroscope manufactured by Shimadzu Corporation), and evaluation was performed with the following criteria. In addition, if the aggregation of metal is observed, the electrodes of the solar battery cells and the wiring members can be electrically connected.
A: Completely aggregated, with no non-aggregated particles.
B: Aggregated but slight non-aggregated particles.
C: Not aggregated at all.
-: Cannot perform coating thus, not measurable.

**[Table 1]**

| | | Example 1 | Example 2 | Example 3 | Example 4 | Example 5 | Example 6 | Example 7 |
|---|---|---|---|---|---|---|---|---|
| Conductive particles | Sn42-Bi58 | 75 | - | 70 | 70 | 70 | 75 | 80 |
| | Sn42-Bi57-Agl | - | 75 | - | - | - | - | - |
| | Sn96.5-Ag3-Cu0.5 | - | - | - | - | - | - | - |
| Thermosetting resins | YL983U | 20 | 20 | - | 25 | 25 | 20 | 12 |
| | TETRAD-X | - | - | 25 | - | - | - | - |
| Curing accelerator | 2P4MHZ | 1 | 1 | 1 | 1 | 1 | 1 | 1 |
| Flux activator | BHPA | 4 | 4 | 4 | 4 | 4 | 4 | 4 |
| Reactive diluents | ED-509S | - | - | - | - | - | - | 3 |
| Viscosity (Pa·s) | | 25 | 27 | 23 | 13 | 18 | 22 | 30 |
| Average particle size of conductive particles (µm) | | 20 | 20 | 20 | 20 | 10 | 90 | 20 |
| Coating properties | | A | A | A | A | A | B | B |
| Aggregability | | A | A | A | B | A | A | A |
| Stability | | A | A | A | B | B | B | A |
| Line width (mm) | | 0.8 | 0.8 | 0.8 | 0.8 | 0.7 | 2.0 | 1.0 |

**[Table 2]**

| | | Com. Ex. 1 | Com. Ex. 2 | Com. Ex. 3 | Com. Ex. 4 | Com. Ex. 5 |
|---|---|---|---|---|---|---|
| Conductive particles | Sn42-Bi58 | 65 | 80 | 70 | - | 92.3 |
| | Sn42-Bi57-Agl | - | - | - | - | - |
| | Sn96.5-Ag3-Cu0.5 | - | - | - | 75 | - |
| Thermosetting resins | YL983U | 30 | 15 | 25 | 20 | 6 |
| | TETRAD-X | - | - | - | - | - |
| Curing accelerator | 2P4MHZ | 1 | 1 | 1 | 1 | 0.3 |
| Flux activator | BHPA | 4 | 4 | 4 | 4 | 1.4 |
| Reactive diluents | ED-509S | - | - | - | - | - |
| Viscosity (Pa·s) | | 8 | 43 | 45 | 20 | 300 |
| Average particle size of conductive particles (µm) | | 20 | 20 | 1 | 10 | 20 |
| Coating properties | | A | C | C | A | C |
| Aggregability | | B | - | - | C | - |
| Stability | | C | B | C | B | C |
| Line width (mm) | | 0.6 | - | - | 1.3 | - |

The conductive adhesive compositions of Examples 1 to 7 could be applied with the non-contact-type dispenser, and the line width thereof was equal to or less than 2.0 mm. In addition, by heating at 160°C, it could be confirmed that the metal particles were aggregated. If the viscosity was less than 20 Pa·s although it was within the range of the present invention as Examples 4 and 5, it was found that the aggregability and stability were slightly degraded. In addition, as Example 6, if the conductive particles having relatively large average particle size of 90 µm were used, although the stability was slightly degraded by the precipitation and the coating properties was also slightly degraded, the aggregability was excellent. In addition, even in Example 7 in which the content of the conductive particles was set to 80% by mass and the viscosity was set to 30 Pa·s using the reactive diluents, it was possible to perform coating with the non-contact-type dispenser and the aggregation of the metal particles was excellent.

On the other hand, in Comparative Example 1 in which the conductive particles was 65% by mass, coating could be performed with the non-contact-type dispenser, and the line width was equal to or less than 2.0 mm, however, a part of the metal particles was not aggregated. If the aggregability is degraded, it is not preferable since sufficient conductivity may not be obtained. In Comparative Examples 2 and 3 in which the viscosity is greater than 30 Pa·s, the coating could not be performed with the non-contact-type dispenser. In Comparative Example 5 in which the metal having a melting point of higher than 210°C was used as the conductive particles, the coating could be performed with the contact-type dispenser, and the line width was equal to or less than 2.0 mm, however, the metal particles was not aggregated at all. In Comparative Example 5 in which the content of the conductive particles was equal to or more than 90% by mass, the viscosity was extremely high and coating could not be performed.

### Reference Signs List

1: Glass, 2: Sealing material, 3a, 3b: Busbar electrodes, 4: Wiring member, 5: Back sheet, 6: Semiconductor wafer, 7: Grid electrode, 8: Rear surface electrode, 10: Conductive adhesive composition, 20: Solar cell, 30: Connected body, 40: Non-contact-type dispenser, 100: Solar cell module

## Claims

1. A conductive adhesive composition comprising conductive particles (A) containing metal having a melting point of equal to or lower than 210°C, a thermosetting resin (B), and a flux activator (C), wherein viscosity of the conductive adhesive composition is 5 to 30 Pa·s, and a content of the conductive particles (A) is 70 to 90% by mass with respect to the total amount of the conductive adhesive composition.

2. The conductive adhesive composition according to claim 1, wherein the metal of the conductive particles (A) contains at least one kind of component selected from bismuth, indium, tin, and zinc.

3. The conductive adhesive composition according to claim 1 or 2, wherein an average particle size of the conductive particles (A) is 2 to 95 µm.

4. The conductive adhesive composition according to any one of claims 1 to 3, further containing a curing agent or a curing accelerator.

5. The conductive adhesive composition according to any one of claims 1 to 4, wherein the thermosetting resin (B) is an epoxy resin.

6. A method for applying a conductive adhesive composition, comprising applying the conductive adhesive composition according to any one of claims 1 to 5 onto a target binding surface by a non-contact-type dispenser.

7. A connected body in which a plurality of solar battery cells are connected via a metal wire,
wherein electrode surfaces of the solar battery cells and the metal wire are connected via the conductive adhesive composition according to any one of claims 1 to 5.

8. A method for producing a solar cell module comprising:
a step of applying the conductive adhesive composition according to any one of claims 1 to 5 onto electrode surfaces of solar battery cells by a non-contact-type dispenser;
a step of laminating a sealing material on both surfaces of the solar battery cells, after disposing a wiring member on the conductive adhesive composition applied onto the electrode surfaces of the solar battery cells;
a step of laminating glass on the sealing material on a light-receiving surface side of the solar battery cells, and a protection film on the sealing material on a rear surface of the solar battery cells; and
a step of sealing the solar battery cells while electrically connecting and bonding the solar battery cells and the wiring member by heating the obtained laminated body.

9. A solar cell module in which electrodes of a plurality of solar battery cells and a wiring member are electrically connected via the conductive adhesive composition according to any one of claims 1 to 5.
